# EUROPÄISCHE PATENTSCHRIFT

(11) **EP 3 299 833 B1**
(45) Veröffentlichungstag und Bekanntmachung des Hinweises auf die Patenterteilung: **25.10.2023**
(21) Anmeldenummer: 17185874.9
(22) Anmeldetag: 11.08.2017
(51) Int. Cl.: G01R 33/48

(54) **VERBESSERTE ERZEUGUNG VON BILDPUNKT-ZEIT-SERIEN EINES UNTERSUCHUNGSOBJEKTES MITTELS MAGNETRESONANZTECHNIK**
ENHANCED GENERATION OF IMAGE POINT TIME SERIES OF AN OBJECT TO BE EXAMINED USING MAGNETIC RESONANCE TECHNOLOGY
GÉNÉRATION AMÉLIORÉE DES SÉRIES CHRONOLOGIQUES DE POINTS IMAGE D'UN OBJET EXAMINÉ AU MOYEN DE LA TECHNIQUE DE RÉSONANCE MAGNÉTIQUE

(30) Priorität: 15.09.2016 DE 102016217675
(43) Veröffentlichungstag der Anmeldung: 28.03.2018
(73) Patentinhaber: Siemens Healthcare GmbH, 91052 Erlangen (DE)
(72) Erfinder: Pfeuffer, Josef, 91358 Kunreuth (DE)

(56) Entgegenhaltungen:
- WO-A2-2015/073894
- DAN MA ET AL: "Magnetic resonance fingerprinting", NATURE, Bd. 495, Nr. 7440, 13. März 2013 (2013-03-13), Seiten 187-192, XP055183037, ISSN: 0028-0836, DOI: 10.1038/nature11971
- WANG ZHE ET AL: "Magnetic Resonance Fingerprinting with compressed sensing and distance metric learning", NEUROCOMPUTING, Bd. 174, 21. Oktober 2015 (2015-10-21), Seiten 560-570, XP029328329, ISSN: 0925-2312, DOI: 10.1016/J.NEUCOM.2015.09.077
- D. J. HOLLAND ET AL: "Compressed sensing reconstruction improves sensitivity of variable density spiral fMRI : CS Improves Sensitivity of VD Spiral fMRI", MAGNETIC RESONANCE IN MEDICINE., Bd. 70, Nr. 6, 6. Februar 2013 (2013-02-06), Seiten 1634-1643, XP055450451, US ISSN: 0740-3194, DOI: 10.1002/mrm.24621
- YANG YANG ET AL.: "SINGLE-SHOT SPIRAL FIRST-PASS PERFUSION IMAGING: FULL HEART COVERAGE WITH HIGH TEMPORAL RESOLUTION", PROCEEDINGS OF THE INTERNATIONAL SOCIETY FOR MAGNETIC RESONANCE IN MEDICINE, ISMRM, 21ST ANNUAL MEETING AND EXHIBITION, SALT LAKE CITY, UTAH, USA, 20-26 APRIL 2013, 7. April 2013 (2013-04-07), XP040632152,
- JOSEF PFEUFFER ET AL.: "Mitigation of Spiral Undersampling Artifacts in Magnetic Resonance Fingerprinting (MRF) by Adapted Interleave Reordering", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Nr. 133, 7. April 2017 (2017-04-07), XP040687701,
- GREGOR KÖRZDÖRFER ET AL.: "Spatial biases in Magnetic Resonance Fingerprinting parameter maps arising from undersampling patterns", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Nr. 3956, 7. April 2017 (2017-04-07), XP040691524,
- Dan Ma ET AL: "Music-based magnetic resonance fingerprinting to improve patient comfort during MRI examinations : MRF-Music", MAGNETIC RESONANCE IN MEDICINE, vol. 75, no. 6, 16 July 2015 (2015-07-16), pages 2303-2314, XP055532819, ISSN: 0740-3194, DOI: 10.1002/mrm.25818
- MAZOR GAL ET AL: "Low rank magnetic resonance fingerprinting", 2016 38TH ANNUAL INTERNATIONAL CONFERENCE OF THE IEEE ENGINEERING IN MEDICINE AND BIOLOGY SOCIETY (EMBC), IEEE, 16 August 2016 (2016-08-16), pages 439-442, XP032979186, DOI: 10.1109/EMBC.2016.7590734 [retrieved on 2016-10-13]
- JANG JINSEONG ET AL: "Medical image matching using variable randomized undersampling probability pattern in data acquisition", 2014 INTERNATIONAL CONFERENCE ON ELECTRONICS, INFORMATION AND COMMUNICATIONS (ICEIC), IEEE, 15 January 2014 (2014-01-15), pages 1-2, XP032653103, DOI: 10.1109/ELINFOCOM.2014.6914453 [retrieved on 2014-09-30]
- INTERNATIONAL SOCIETY FOR MAGNETIC RESONANCE IN MEDICINE, ISMRM, 2030 ADDISON STREET, 7TH FLOOR, BERKELEY, CA 94704 USA, no. 4214, 15 May 2015 (2015-05-15), XP040669890,

## Beschreibung

Die Erfindung betrifft eine Verbesserung von mittels Magnetresonanztechnik erzeugten Bildpunkt-Zeit-Serien.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einer Magnetresonanzanlage in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Eine Magnetresonanz-Bildgebung mittels eines Magnetresonanzanlage kann dazu dienen, eine Anwesenheit und/oder eine Verteilung eines Stoffs, welcher sich in einem Untersuchungsobjekt befindet, zu bestimmen. Der Stoff kann dabei beispielsweise ein, möglicherweise pathologisches, Gewebe des Untersuchungsobjekts, ein Kontrastmittel, eine Markierungssubstanz oder ein Stoffwechselprodukt sein.

Informationen über die vorliegenden Stoffe können dabei auf vielfältige Weise aus den aufgenommenen Messdaten gewonnen werden. Eine relativ einfache Informationsquelle sind z.B. aus den Messdaten rekonstruierte Bilddaten. Es gibt jedoch auch komplexere Verfahren, die, z.B. aus Bildpunkt-Zeit-Serien von aus sukzessive gemessenen Messdatensätzen rekonstruierten Bilddaten, Informationen über das untersuchte Untersuchungsobjekt ermitteln.

Zu derartigen Verfahren gehören beispielsweise Magnetresonanz-Fingerprinting-Verfahren (MRF-Verfahren), bei denen Signalverläufe von aus zeitlich nacheinander mit verschiedenen Aufnahmeparametern aufgenommenen Messdaten rekonstruierten Bilddaten mittels Mustererkennungsverfahren ("pattern recognition") mit Signalverläufen einer zuvor ermittelten Datenbank von für bestimmte Stoffe charakteristischen Signalverläufen ("dictionary") verglichen werden, um die in den aus den Messdaten rekonstruierten Bilddaten repräsentierten Stoffe bzw. die räumliche Verteilung von gewebespezifischen Parametern (wie die Transversalrelaxation T2 oder die Longitudinalrelaxation T1; sogenannte T1- und T2-Karten) in dem abgebildeten Untersuchungsobjekt zu ermitteln.

Magnetresonanz-Fingerprinting-Verfahren sind beispielsweise in dem Artikel von Ma et al., "Magnetic Resonance Fingerprinting", Nature, 495: S. 187-192 (2013), dem Artikel von Jiang et al., ""MR Fingerprinting Using Fast Imaging with Steady State Precession (FISP) with Spiral Readout", Magnetic Resonance in Medicine 74: S. 1621-1631 (2015) oder auch dem Artikel von Cloos et al. "Online Radial Multiband Magnetic Resonance Fingerprinting", ISMRM 2016: S. 608 bekannt.

In dem genannten Artikel von Jiang et al. wird ein MRF-Verfahren beschrieben, bei dem eine FISP ("Fast Imaging with Steady State Precession")-Sequenz verwendet wird, die 1000 Mal unter Variation der Wiederholzeit TR und des Flipwinkels wiederholt wird, wobei bei jeder Wiederholung Messdaten entlang einer spiralförmigen k-Raum-Trajektorie aufgenommen werden. In dem beschriebenen Verfahren werden 24 Wiederholungen benötigt, um das k-Raum-Zentrum mit der k-Raum-Trajektorie gemäß Nyquist vollständig abzutasten und sogar 48 Wiederholungen, um insgesamt eine Auflösung von 256*256 zu erreichen, bei der auch der periphere k-Raumbereich gemäß Nyquist vollständig abgetastet ist. Die verwendete k-Raum-Trajektorie wird daher in jeder Wiederholung um einen Winkelschritt von 360°/48 = 7,5° rotiert. Ein Messdatensatz einer Wiederholung, aus dem Bilddaten rekonstruiert werden, ist somit 48-fach unterabgetastet. Daher weisen die rekonstruierten Bilddaten, aus denen die mit der Datenbank zu vergleichenden Bildpunkt-Zeit-Serien erstellt werden, starke Unterabtastungs-Artefakte auf. Obwohl Jiang et al. in dem Artikel schließen, dass diese Unterabtastungsartefakte sich insgesamt herausmitteln und daher keinen Einfluss auf die Parameterkarten haben, die als Ergebnisse des Vergleichs mit der Datenbank erhalten werden, können doch räumliche fehlerhafte Abweichungen /Verschiebungen ("spatial bias"), die auch als Shading-Artefakte bezeichnet werden, in den Parameterkarten auftreten.

Weitere MRF-Verfahren sind beispielsweise in den Artikeln von Ma et al., "Music-based magnetic resonance fingerprinting to improve patient comfort during MRI examinations: MRF-Music", Magnetic Resonance in Mdicine 75: S. 2303-2314 (2015), oder Gal et al., "Low rank mangetic resonance fingerprinting", 38th annual international conference of the IEEE engineering in medicine and biology society (EMBC): S.439-442 (2016), oder Jingseong et al., "Medical image matching using variable randomized undersampling probability pattern in data acquisition" international conference on electronics, information and communications (ICEIC): S. 1-2 (2014), oder Cloos et al., "Rapid multiparametric mapping near orthopedic implants at 3T using plug & play parallel transmission",ISMRM 2015: S.4214,

von Ma et al., "Magnetic Resonance Fingerprinting", Nature, 495: S. 187-192 (2013), dem Artikel von Jiang et al., ""MR Fingerprinting Using Fast Imaging with Steady State Precession (FISP) with Spiral Readout", Magnetic Resonance in Medicine 74: S. 1621-1631 (2015) oder auch dem Artikel von Cloos et al. "Online Radial Multiband Magnetic Resonance Fingerprinting", ISMRM 2016: S. 608, oder der WO2015073894A2 beschrieben.

Ein weiteres Beispiel für Verfahren, die aus Bildpunkt-Zeit-Serien von aus sukzessive gemessenen Messdatensätzen rekonstruierten Bilddaten Informationen über das Untersuchungsobjekt ableiten, sind Verfahren der funktionellen Magnetresonanzbildgebung (fMRI). Bei der funktionellen Magnetresonanz-bildgebung werden MR-Bilder des Gehirns eines Probanden oder Patienten aufgenommen während dieser verschiedenen Stimuli ausgesetzt wird. Aus einem Vergleich von Bildpunkt-Zeit-Serien der aufgenommenen MR-Bilder mit dem zeitlichen Verlauf der jeweiligen Stimuli werden Informationen über bei den jeweiligen Stimuli aktive Gehirnregionen gewonnen. Zu den fMRI-Verfahren gehören beispielsweise DSC ("dynamic susceptibility contrast")-Verfahren, BOLD ("blood oxygenation level-dependent")-Verfahren oder auch VASO ("vascular space occupancy")-Verfahren, wie sie z.B. in dem Artikel von Belliveau et al., "Functional Mapping oft he Human Visual Vortex by Magnetic Resonance Imaging", Science 254: S. 716-719 (1991), in dem Artikel von Ogawa et al., "Brain magnetic ressonance imaging with contrast dependent on blood oxygenation", Proc. Natl. Acad. Sci. 87:S. 9868-9872 (1990) oder in dem Artikel von Lu et al., "Functional Magnetic Resonance Imaging Based on Changes in Vascular Space Occupancy" Magnetic Resonance in Medicine 50: S. 263-274 (2003) beschrieben werden.

Beispielsweise bei BOLD-fMRI-Verfahren wird in der Regel eine zeitliche Serie von z.B. T2*-sensitiven Bilddatensätzen aufgenommen, in denen temporäre Signaländerungen durch eine statistische Analyse mit Vergleich zu einem funktionalen Paradigma, z.B. auch räumliche Korrelationen in charakteristischen zeitlichen Signalverläufen an Ruhezuständen ("resting state fmri") festgestellt werden. Dabei kann z.B. eine 2D-Multi-Schicht-Gradienten-EPI-Sequenz (EPI: "echo planar imaging") mit einer "zick-zack" kartesischen k-Raum-Trajektorie ("blipped EPI") oder auch mit einer spiralförmigen k-Raum-Trajektorie ("spiral EPI") eingesetzt werden, um die Messdaten aufzunehmen. Dabei werden weitverbreitet sogenannte "sin-gle-shot"-Verfahren verwendet, bei denen nach einer Anregung ein vollständiger Satz an Messdaten, z.B. für eine Schicht, aufgenommen werden, aus denen die Bilddaten für die Bildpunkt-Zeit-Serien rekonstruiert werden. Diese single-shot-Verfahren benötigen jedoch längere Wiederholzeiten TR je grö-βer die Auflösung der aufgenommenen Messdaten sein soll. Lange Wiederholzeiten TR können aber zu Off-Resonanz-Artefakten, Verzerrungs- oder Blurring-Artefakten, führen.

Um die Wiederholzeiten TR trotz höherer Auflösung nicht zu verlängern, können sogenannte parallele Akquisitionstechniken (PAT: "Parallel Acquisition Technique"), wie z.B. GRAPPA ("GeneRalized Autocalibrating Partially Parallel Acquisition") oder SENSE ("Sensitivity Encoding"), bei denen mit Hilfe von mehreren RF-Spulen nur eine gemäß dem Nyquist-Theorem im k-Raum unterabgetastete Anzahl an Messdaten aufgenommen werden, eingesetzt werden. Die "fehlenden" Messdaten werden in diesen Verfahren auf Basis von Sensitivitätsdaten der verwendeten RF-Spulen und Kalibrierungsdaten aus den gemessenen Messdaten ergänzt bevor die Bilddaten rekonstruiert werden. Dadurch, dass nur ein Teil der eigentlich für eine vollständige Abtastung benötigten Messdaten aufgenommen werden (typischerweise z.B. nur die Hälfte oder ein Viertel), wird die für das Auslesen der Messdaten benötigte Auslesezeit und damit die Wiederholzeit reduziert. Allerdings werden die genannten Sensitivitätsdaten der RF-Spulen und Kalibrierungsdaten benötigt, was zusätzliche Messungen erfordert.

Eine andere Möglichkeit, um die Wiederholzeiten kurz zu halten und Off-Resonanz-Artefakte zu vermeiden ist es, sogenannte "multiple-shot"-Verfahren zu verwenden, in denen die für eine gemäß Nyquist vollständige Abtastung erforderlichen Messdaten auf mehrere Wiederholungen aufgeteilt werden, sodass nach einer Anregung nur ein Teil der für eine gemäß Nyquist vollständige Abtastung erforderlichen Messdaten aufgenommen wird. Aus den in den mehreren Wiederholungen aufgenommenen Messdaten werden dann die für die Bildpunkt-Zeit-Serien benötigten Bilddaten rekonstruiert. Diese Vorgehensweise hat jedoch auch Nachteile, denn einerseits kann die Aufteilung der Messdaten auf verschiedene Wiederholungen zu Phasenfehlern zwischen den Messdaten der verschiedenen Wiederholungen, auch Segmentierungs-Artefakte genannt, führen, andererseits ist die Zeit, die für einen gemäß Nyquist vollständigen Datensatz benötigt wird, entsprechend der benötigten Wiederholungen ein Vielfaches der Wiederholzeit TR, wodurch die Messdauer insgesamt stark erhöht wird. Das ist insbesondere bei Event-bezogenen ("event-related") fMRI-Verfahren und auch Ruhezustands- ("resting state") fMRI-Verfahren ein großer, kaum zu akzeptierender Nachteil.

Ein weiteres Verfahren, um die Anzahl der aufzunehmenden Messdaten und damit die Messzeiten zu verringern, ist das sogenannte "Compressed Sensing". Ein derartiges Verfahren ist z.B. in dem Artikel von Yang et al., "Single-Shot Spiral First-Pass Perfusion Imaging: Full Heart Coverage with High Temporal Resolution", Proceedings of the International Society for Magnetic Resonance in Medicine 21: 4556 (2013) beschrieben. In dem Artikel von Holland et al., "Compressed Sensing Reconstruction Improves Sensitivity of Variable Density Spiral fMRI" Magnetic Resonance in Medicine 70: S. 1634-1643 (2013) wird ein Verfahren zur funktionellen MR-Bildgebung unter Einsatz von Compressed Sensing zur Verbesserung der Sensitivität der Datenaufnahme beschrieben. Der Artikel vom Wang et al., "Magnetic Resonance Fingerprinting with compressed sensing and distance metric learning", Neurocomputing 174: S. 560-570 (2015) offenbart ein MRF-Verfahren unter Einsatz von Compressed Sensing.

Der Erfindung liegt die Aufgabe zugrunde, die genannten Nachteile bei MR-Verfahren, welche Bildpunkt-Zeit-Serien zur Gewinnung von Informationen über ein Untersuchungsobjekt nutzen, zu vermeiden bzw. zu reduzieren.

Die Aufgabe wird gelöst durch ein Verfahren zur Erzeugung einer Bildpunkt-Zeit-Serie eines Untersuchungsobjektes mittels Magnetresonanztechnik gemäß Anspruch 1, eine Magnetresonanzanlage gemäß Anspruch 8, ein Computerprogrammprodukt gemäß Anspruch 9 sowie einen elektronisch lesbaren Datenträger gemäß Anspruch 10.

Der Erfindung liegt die Erkenntnis zugrunde, dass bei einer jeweils gemäß Nyquist unterabgetasteten Aufnahme von Messdaten in mehreren Wiederholungen entlang variierter k-Raum-Trajektorien die Reihenfolge der k-Raum-Trajektorien entlang derer in den aufeinanderfolgenden Wiederholungen Messdaten aufgenommen werden, Einfluss auf die in den Messdaten enthaltenen Artefakte, insbesondere die enthaltenen Unterabtastungsartefakte und Einfaltungsartefakte, hat.

Diese sind nicht allein durch den Grad der Unterabtastung bestimmt, sondern hängen auch z.B. von Hardware-Komponenten der verwendeten Magnetresonanzanlage ab, wie z.B. der Gradientenleistung. Dies ist insbesondere durch gewisse gerätespezifische Inhomogenitäten und Soll-Abweichungen bedingt. Durch derartige Inhomogenitäten und Soll-Abweichungen werden die angestrebten, geplanten k-Raum-Trajektorien tatsächlich nicht exakt eingehalten, wodurch Rest-Momente der geschalteten Gradienten erhalten bleiben können. Diese Rest-Momente unterscheiden sich je nach den, z.B. für das Auslesen der Messdaten, geschalteten Gradienten, wodurch für verschiedene k-Raum-Trajektorien verschiedene Rest-Momente bestehen bleiben, was zu (weiteren) Artefakten führt.

Weitere Gründe, warum tatsächlich gemessene k-Raum-Trajektorien von den geplanten k-Raum-Trajektorien abweichen können und damit warum Artefakte auftreten können, sind beispielsweise unkompensierte verbleibende Wirbelströme und Wechselwirkungen/Interferenzen ("cross terms"), Inhomogenitäten im B1-Feld oder auch Fehler in der Zeiteinteilung der Sequenz.

Ein erfindungsgemäßes Verfahren zur Erzeugung einer Bildpunkt-Zeit-Serie eines Untersuchungsobjektes mittels Magnetresonanztechnik umfasst die Schritte:
- In einer ersten Wiederholung, Einstrahlen von RF-Pulsen, Schalten von Gradienten und Auslesen von durch die eingestrahlten RF-Pulse und die geschalteten Gradienten erzeugten Echosignalen gemäß einer Pulssequenz derart, dass entlang einer ersten k-Raum-Trajektorie Messdaten nach einer Anregung mit einem RF-Anregungspuls aufgenommen und in einem Messdatensatz gespeichert werden, wobei der Messdatensatz gemäß Nyquist unterabgetastet ist,
- Mehrmaliges Wiederholen der Pulssequenz unter Schaltung von jeweils anderen Gradienten und optional unter Einstrahlung von jeweils anderen RF-Pulsen derart, dass bei jeder Wiederholung nach dem einen RF-Anregungspuls Messdaten entlang einer weiteren k-Raum-Trajektorie gemessen und in jeweiligen Messdatensätzen gespeichert werden, wobei die Wiederholungen derart durchgeführt werden, dass in aufeinanderfolgenden Wiederholungen Messdaten entlang optimiert gewählten k-Raum-Trajektorien gemessen werden,
- Rekonstruieren eines Bilddatensatzes pro Messdatensatz,
- Bilden mindestens einer Bildpunkt-Zeit-Serie für mindestens einen Bildpunkt aus den rekonstruierten Bilddatensätzen, die eine Signalintensität des Bildpunktes im Verlauf der Aufnahmezeiten der Messdatensätze wiedergibt,
- Speichern der mindestens einen gebildeten Bildpunkt-Zeit-Serie,
dadurch gekennzeichnet, dass
die Wiederholungen derart durchgeführt werden, dass in aufeinanderfolgenden Wiederholungen Messdaten entlang optimiert gewählten k-Raum-Trajektorien (Ti+1) gemessen werden, wobei für die Optimierung Ergebnisse von nach verschiedenen Kriterien gewählten aufeinanderfolgenden k-Raum-Trajektorien verglichen werden,
wobei die Wahl der nacheinander zu messenden k-Raum-Trajektorien (Tᵢ, Tᵢ₊₁) gemäß mindestens eines der folgenden Kriterien optimiert ist: eine Reduzierung von Artefakten in den rekonstruierten Bilddatensätzen, eine Reduzierung einer räumlichen und/oder zeitlichen Verschiebung von Intensitätswerten in den rekonstruierten Bilddatensätzen, und
wobei die weiteren k-Raum-Trajektorien (Tᵢ₊₁) durch eine schrittweise Rotation gemäß einer Rotationsschrittweite und/oder durch eine schrittweise Translation gemäß einer Translationsschrittweite bestimmt sind, und
wobei die k-Raum-Trajektorien (Tᵢ, Tᵢ₊₁), entlang derer in aufeinanderfolgenden Wiederholungen Messdaten gemessen werden, derart gewählt sind, dass eine k-Raum-Trajektorie (Tᵢ₊₁) durch eine Rotation einer unmittelbar vorhergehenden k-Raum-Trajektorie (Tᵢ) um ein Vielfaches einer kleinsten Rotationsschrittweite zwischen zwei im Rahmen aller Wiederholungen zu verwendenden k-Raum-Trajektorien bestimmt ist, wenn die weiteren k-Raum-Trajektorien durch Rotation der ersten k-Raum-Trajektorie bestimmt sind, und/oder dass eine k-Raum-Trajektorie (Tᵢ₊₁) durch eine Translation einer unmittelbar vorhergehenden k-Raum-Trajektorie (Tᵢ) um ein Vielfaches einer kleinsten Translationsschrittweite zwischen zwei im Rahmen aller Wiederholungen zu verwendenden k-Raum-Trajektorien bestimmt ist, wenn die weiteren k-Raum-Trajektorien durch Translation der ersten k-Raum-Trajektorie bestimmt sind.

Durch die erfindungsgemäße Optimierung der Wahl der k-Raum-Trajektorien, entlang derer in aufeinanderfolgenden Wiederholungen Messdaten aufgenommen werden, können störende Artefakte in aus den Messdaten einer Wiederholung rekonstruierten Bilddaten vermieden oder zumindest reduziert werden. Dadurch können insbesondere mittels MRF-Verfahren erzielte Ergebnisse z.B. für Parameterkarten des untersuchten Untersuchungsobjekts verbessert werden.

Durch die erfindungsgemäße Optimierung der Wahl der k-Raum-Trajektorien, entlang derer Messdaten nacheinander aufgenommen werden sollen, können auch bei fMRI-Verfahren die für die Bildpunkt-Zeit-Serien benötigten Bilddaten aus unterabgetasteten Messdaten, die in einer Wiederholung gemessen wurden, rekonstruiert werden, ohne die Qualität der aus den Bildpunkt-Zeit-Serien zu gewinnenden Informationen zu beeinträchtigen. Dabei werden insbesondere Segmentierungs-Artefakte vermieden, da die Wiederholzeiten TR gegenüber gemäß Nyquist vollständigen Aufnahmen verkürzt sind.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung und einer Optimierungseinheit.

Ein erfindungsgemäßes Computerprogrammprodukt umfasst ein 2. Computerprogramm welches ein erfindungsgemäßes Verfahren auf einer Steuereinrichtung einer Magnetresonanzanlage implementiert, wenn es auf der Steuereinrichtung ausgeführt wird.

Das Computerprogrammprodukt ist direkt in einen Speicher einer Steuereinrichtung einer Magnetresonanzanlage ladbar, mit Programmcode-Mitteln, um ein erfindungsgemäßes Verfahren auszuführen, wenn das Computerprogramm in der Steuereinrichtung ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
- Fig. 1: ein schematisches Ablaufdiagramm eines erfindungsgemäßen Verfahrens,
- Fig. 2: ein grob schematisch dargestelltes Pulssequenzdiagramm, wie es für ein erfindungsgemäßes Verfahren eingesetzt werden kann,
- Fig. 3: ein Beispiel einer möglichen Verteilung von k-Raum-Trajektorien,
- Fig. 4: ein Beispiel einer herkömmlichen Auswahl von durch Rotation bestimmter weiterer k-Raum-Trajektorien,
- Fig. 5: ein Beispiel einer erfindungsgemäßen Auswahl von durch Rotation bestimmter weiterer k-Raum-Trajektorien,
- Fig. 6: ein weiteres Beispiel einer Auswahl von durch Translation bestimmter weiterer k-Raum-Trajektorien,
- Fig. 7: eine schematisch Darstellung des Zusammenhangs von Messdatensätzen und Bilddatensätzen im zeitlichen Verlauf,
- Fig. 8: ein Beispiel einer erfindungsgemäß erstellten Bildpunkt-Zeit-Serie,
- Fig. 9: ein weiteres Beispiel einer erfindungsgemäß erstellten Bildpunkt-Zeit-Serie,
- Fig. 10: ein Vergleich einer nicht auf Grundlage von erfindungsgemäß erzeugten Bildpunkt-Zeit-Serien ermittelten Parameterkarte mit einer auf Grundlage von erfindungsgemäß erzeugten Bildpunkt-Zeit-Serien ermittelten Parameterkarte,
- Fig. 11: eine schematisch dargestellte erfindungsgemäße Magnetresonanzanlage.

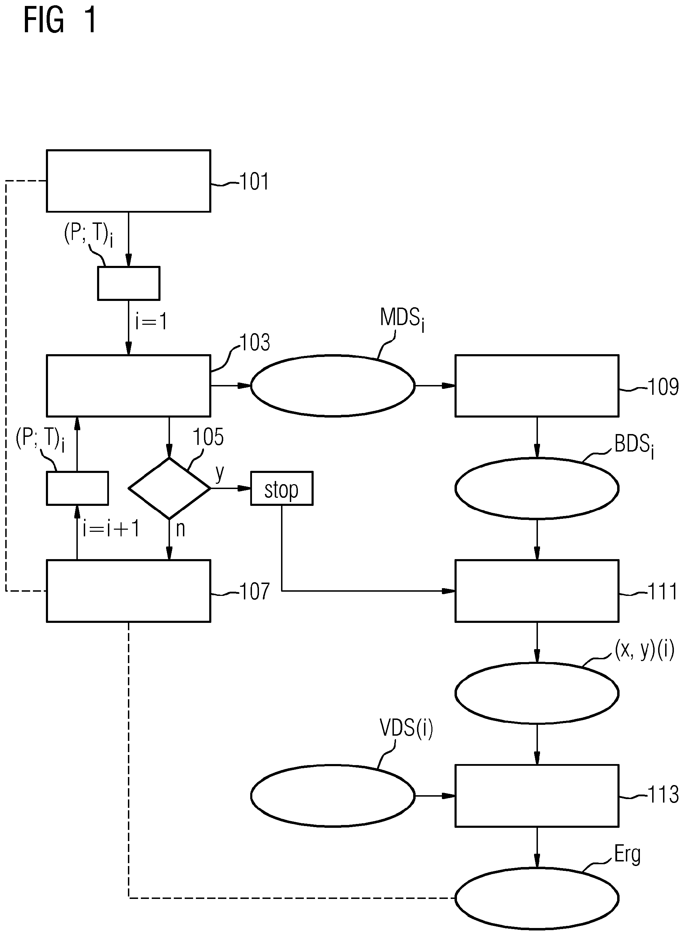

Figur 1 ist ein schematisches Ablaufdiagramm eines erfindungsgemäßen Verfahrens zur Erzeugung einer Bildpunkt-Zeit-Serie eines Untersuchungsobjektes mittels Magnetresonanztechnik.

Dabei wird eine Pulssequenz z.B. entsprechend einem gewünschten Kontrast oder anderer gewünschter Eigenschaften der mit der Pulssequenz auslesbaren Messdaten auf übliche Weise gewählt (Block 101).

Die Pulssequenz wird mit in einer ersten Wiederholung (i=1) mit einem ersten Satz an Parametern Pᵢ durchgeführt, wobei Messdaten entlang einer ersten k-Raum-Trajektorie Tᵢ abgetastet werden sollen (P;T)ᵢ. Eine k-Raum-Trajektorie entlang derer Messdaten in einer Wiederholung gemessen werden kann den k-Raum kartesisch, spiralförmig, radial oder auch in einer die vorgenannten Abtastarten mischenden oder sogar entlang einer frei gestalteten Trajektorie abtasten.

Gemäß der Pulssequenz werden RF-Pulse in ein Untersuchungsobjekt eingestrahlt, Gradienten geschaltet und durch die eingestrahlten RF-Pulse und die geschalteten Gradienten erzeugte Echosignalen ausgelesen (Block 103). Dabei werden nach einer Anregung mit einem RF-Anregungspuls Messdaten entlang der k-Raum-Trajektorie Tᵢ aufgenommen und in einem Messdatensatz MDSᵢ gespeichert. Die k-Raum-Trajektorie und die Abtast-Auflösung sind dabei dergestalt, dass der Messdatensatz MDSᵢ gemäß Nyquist unterabgetastet ist. Aus jedem Messdatensatz MDSᵢ wird ein Bilddatensatz BDSᵢ rekonstruiert (Block 109), wobei auch nur ein Teil der in dem Messdatensatz MDSᵢ enthaltenen Messdaten für die Rekonstruktion verwendet werden kann. Somit erhält man einen Bilddatensatz BDSᵢ pro Wiederholung i, d.h. insgesamt N Bilddatensätze BDSᵢ.

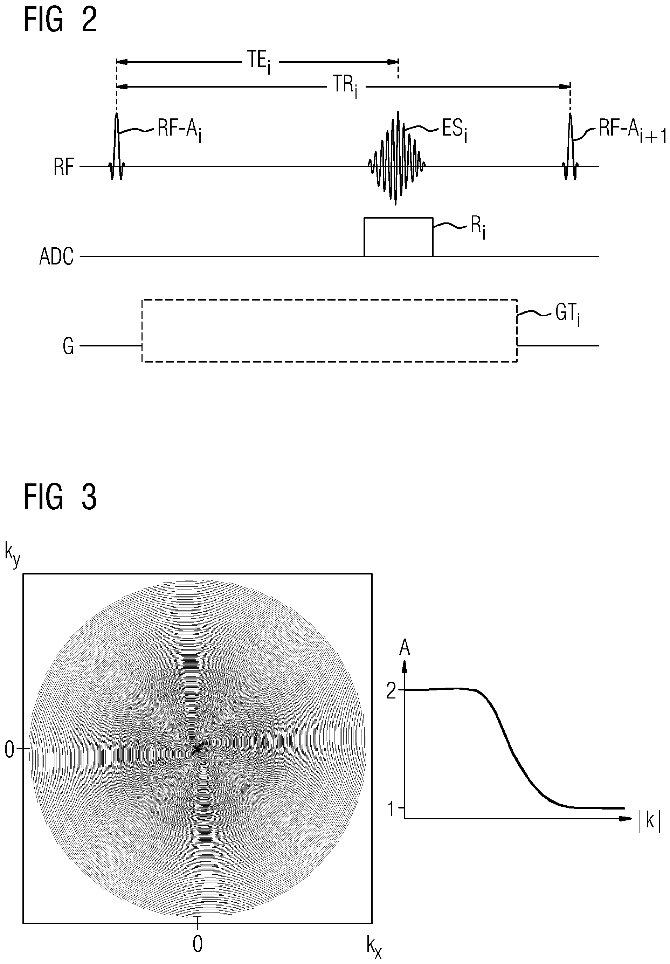

Ein grob schematisches Beispiel einer anwendbaren Pulssequenz ist in Figur 2 anhand eines Pulssequenzdiagramms dargestellt. Nach einem Anregungspuls RF-Aᵢ wird nach einer Echozeit TEᵢ ein Echosignal ESᵢ, jeweils dargestellt in der obersten, die Hochfrequenzaktivität darstellenden Zeile (RF), in einem Auslesezeitraum Rᵢ ausgelesen (ADC). Je nach Pulssequenz können zwischen dem Anregungspuls RF-Aᵢ und dem Echosignal ESᵢ auch noch weitere RF-Pulse geschaltet werden, auf deren Darstellung der Übersichtlichkeit halber verzichtet wurde. Nach einem Anregungspuls RF-Aᵢ wird ein Gradientenzug GTᵢ, der Gradienten in allen Gradientenrichtungen G umfassen kann, geschaltet, dessen genaue Ausgestaltung wiederum von der Art der gewählten Pulssequenz und der k-Raum-Trajektorie Tᵢ abhängt, und dem Fachmann grundsätzlich bekannt ist. Daher ist der Gradientenzug GTᵢ nur durch einen Kasten angedeutet. Nach einer Wiederholzeit TRᵢ, die erfindungsgemäß variieren kann, wird das Pulssequenzdiagramm wiederholt, wie durch den folgenden Anregungspuls RF-Aᵢ₊₁ angedeutet ist, wobei in jeder Wiederholung i andere Gradienten in dem Gradientenzug GTᵢ geschaltet und/oder andere RF-Pulse eingestrahlt werden können. Beispielsweise kann in jeder Wiederholzeit TRᵢ ein Flipwinkel eingestrahlter RF-Pulse, insbesondere des Anregungspulses RF-Aᵢ variiert werden. Insgesamt werden N Wiederholungen durchgeführt (i=1, ..., N), wobei N eine natürliche Zahl größer als Eins ist und, je nach Anwendung, auch mehrere hundert bis mehrere tausend sein kann.

In einer Abfrage 105 wird abgefragt, ob bereits alle N gewünschten Wiederholungen durchgeführt und die entsprechenden N Messdatensätze MSDi gespeichert wurden. Ist dies nicht der Fall ("n", Abfrage 105), wird eine für die nächste Wiederholung optimale k-Raum-Trajektorie gewählt und die Parameter der Pulssequenz entsprechend angepasst und ggf. zusätzlich variiert (Block 107). In der Regel wird sich eine gewählte weitere k-Raum-Trajektorie Tᵢ₊₁ von einer vorhergehenden k-Raum-Trajektorie Tᵢ unterscheiden. Mit dem so erhaltenen nächsten Parametern Pᵢ₊₁ und der gewählten weiteren k-Raum-Trajektorie Tᵢ₊₁ ((P;T)ᵢ₊ₜ) wird die Pulssequenz wiederholt und somit eine erneute Messung (Block 103) durchgeführt, derart, dass in aufeinanderfolgenden Wiederholungen Messdaten entlang den optimiert gewählten k-Raum-Trajektorien Tᵢ, Tᵢ₊₁ gemessen werden.

Die weitere k-Raum-Trajektorie Tᵢ₊₁ ist hierbei beispielsweise durch Anwenden einer Rotation und/oder einer Translation auf die erste k-Raum-Trajektorie T1 oder durch eine Verkürzung einer anderen k-Raum-Trajektorie bestimmt. Es können auch andere geometrische Operationen, wie Spiegelungen oder Vergrö-βerungen oder Verkleinerungen, eingesetzt werden, um weitere k-Raum-Trajektorien aus bereits gewählten k-Raum-Trajektorien zu bestimmen. Es ist weiterhin denkbar, dass z.B. Korrekturen, beispielsweise bezüglich Wirbelströmen und/oder Verzögerungen, angewendet werden, welche z.B. in kx-, ky und kz-Richtung unterschiedlich sein können, und die die jeweilige k-Raum-Trajektorie beeinflussen. Z.B. kann eine weitere k-Raum-Trajektorie auch als Teilstück einer anderen zu verwendenden k-Raum-Trajektorie konstruiert sein, die gegebenenfalls noch rotiert und/oder verschoben werden kann. Die verwendeten Rotationen und/oder Translationen sowie ggf. Teilstücke, auf die eine weitere k-Raum-Trajektorie im Vergleich zu einer anderen verkürzt wird, werden derart gewählt, dass der k-Raum in einer gewünschten Art und Weise durch alle verwendeten k-Raum-Trajektorien abgedeckt wird.

Hierzu kann auch zunächst eine Menge von zu verwendenden k-Raum-Trajektorien Tᵢ festgelegt werden, die für die Wiederholungen verwendet werden sollen, und die z.B. den k-Raum insgesamt in einer gewünschten Art und Weise abdecken, z.B. um eine gewünschte Über- oder Unter-Abtastung oder eine Abtastungs-Verteilung im relevanten k-Raum zu erreichen. Grundsätzlich können hierbei auch k-Raum-Trajektorien, die nicht durch geometrische Operationen voneinander abgeleitet werden können gewählt werden. Die gewünschte Abtastungs-Verteilung kann hierbei insbesondere in Bezug auf eine gewünschte Verwendung der erzeugten Bildpunkt-Zeit-Serien bestimmt werden. Die Menge der verwendenden k-Raum-Trajektorien Tᵢ legt somit auch eine Anzahl n an verschiedenen insgesamt anzuwendenden k-Raum-Trajektorien Tᵢ fest.

Ein Beispiel einer möglichen Verteilung von k-Raum-Trajektorien ist in Figur 3 gezeigt. Hierbei wurde eine spiralförmige k-Raum-Trajektorie verwendet, die in Rotationsschritten von 7,5° (=360°/48) um das k-Raumzentrum rotiert wurde, um im Bereich des k-Raumzentrums insgesamt eine Überabtastung mit dem Faktor 2 und im peripheren Bereich insgesamt eine vollständige Abtastung gemäß Nyquist zu erreichen. Um diese gewünschte Abtastung zu erreichen, ist eine Mindestanzahl n von k-Raum-Trajektorien anzuwenden, entlang derer Messdaten in verschiedenen Wiederholungen aufgenommen werden (hier: n=48). Die Verteilung der hier geltenden radialen Abtastrate "A" gemäß Nyquist ist rechts über ansteigende Werte im k-Raum aufgetragen. Bei dieser Wahl der Abdeckung des k-Raums und der Form der k-Raum-Trajektorie kann es, insbesondere bei einer späteren Verwendung einer erfindungsgemäß erzeugten Bildpunkt-Zeit-Serie im Rahmen eines MRF-Verfahrens, sinnvoll sein, jede der hier n=48 k-Raum-Trajektorien zumindest in einer Wiederholung zu verwenden oder sogar jede der n=48 k-Raum-Trajektorien in allen Wiederholungen möglichst gleich oft zu verwenden. Damit kann erreicht werden, dass ein aus den insgesamt aufgenommenen Messdaten rekonstruiertes sekundäres Bild, beispielsweise eine Parameterkarte, möglichst frei von durch eine ansonsten vorhandene zeitliche Unterabtastung verursachten Artefakten ist.

So kann z.B. bei der Wahl der k-Raum-Trajektorien, entlang derer in aufeinanderfolgenden Wiederholungen Messdaten gemessen werden sollen, eine Anzahl an verschiedenen insgesamt anzuwendenden k-Raum-Trajektorien und/oder einen Grad der Unterabtastung eines Messdatensatzes berücksichtigt werden.

Bei der Wahl der gewünschten Abtastung kann eine zumindest in bestimmten k-Raum-Bereichen, z.B. in einem zentralen Bereich und/oder in einem peripheren Bereich, möglichst homogene Abtastung gewünscht sein. Wie in dem Beispiel der Figur 3 kann auch eine zum k-Raumzentrum hin dichter werdende Abtastung gewünscht sein. Um eine homogene Verteilung der Abtastung zu erhalten, kann beispielsweise bei einer kartesischen k-Raum-Trajektorie eine maximale Translation zwischen zwei zu verwendenden k-Raum-Trajektorien bestimmt werden und diese maximale Translation einer gewünschten Abtastdichte entsprechend in äquidistante Translationsschritte eingeteilt werden, um die eine äußerste k-Raum-Trajektorie verschoben wird, um eine weitere zu verwendende k-Raum-Trajektorie zu erhalten. Die Länge der äquidistanten Translationsschritte kann hierbei als Quotient der maximalen Translation geteilt durch die Anzahl N der durchzuführenden Wiederholungen oder geteilt durch eine (auch nicht-ganzzahlige) Zahl kleiner als N bestimmt werden. Analog kann auch bei einer Bestimmung der weiteren k-Raum-Trajektorien durch Rotation eine maximale Rotation (360°) durch die Anzahl N der durchzuführenden Wiederholungen oder durch eine (auch nicht-ganzzahlige) Zahl kleiner N geteilt werden, um Rotationsschritte zu bestimmen. Auf diese Weise kann eine Menge an im Verlauf der Wiederholungen zumindest einmal zu verwendenden k-Raum-Trajektorien festgelegt werden, die bei der Wahl der k-Raum-Trajektorien, entlang derer in aufeinanderfolgenden Wiederholungen Messdaten gemessen werden sollen, berücksichtigt werden können. Je größer die Zahl durch die die maximale Translation bzw. die maximale Rotation geteilt wird, d.h. je kleiner die Translationsschritte bzw. Rotationsschritte, desto höher wird die Auflösung bezüglich des insgesamt abgetasteten k-Raums.

Die weiteren k-Raum-Trajektorien sind dann durch eine schrittweise Rotation gemäß einer gewünschten Rotationsschrittweite und/oder durch eine schrittweise Translation gemäß einer gewünschten Translationsschrittweite bestimmt.

Aus einer solchen Menge an im Verlauf der Wiederholungen zumindest einmal zu verwendenden k-Raum-Trajektorien können k-Raum-Trajektorien, entlang derer in aufeinanderfolgenden Wiederholungen Messdaten gemessen werden sollen, zufällig gewählt werden.

Aus dieser Menge an im Verlauf der Wiederholungen zumindest einmal zu verwendenden k-Raum-Trajektorien können k-Raum-Trajektorien, entlang derer in aufeinanderfolgenden Wiederholungen Messdaten gemessen werden sollen, in einer nichtchronologischen Reihenfolge gewählt werden. Auf diese Weise können Artefakte durch nicht vollständig kompensierte Gradientenmomente oder versehentliches Messen von Signalen aus einer vorhergehenden Wiederholung vermieden oder zumindest minimiert werden.

Aus dieser Menge an im Verlauf der Wiederholungen zumindest einmal zu verwendenden k-Raum-Trajektorien können k-Raum-Trajektorien, entlang derer in aufeinanderfolgenden Wiederholungen Messdaten gemessen werden sollen, derart gewählt werden, dass in aufeinanderfolgenden Wiederholungen Messdaten entlang von k-Raum-Trajektorien, die alternierende Gradienten aufweisen, gemessen werden. Auf diese Weise werden störende Wirbelströme vermieden.

In jedem Fall kann die Wahl der nacheinander zu messenden k-Raum-Trajektorien gemäß mindestens eines der folgenden Kriterien optimiert werden: eine Reduzierung von Artefakten in den rekonstruierten Bilddatensätzen, eine Reduzierung einer räumlichen und/oder zeitlichen Verschiebung von Intensitätswerten in den rekonstruierten Bilddatensätzen. In einem einfachen Fall können für eine solche Optimierung Ergebnisse von z.B. nach verschiedenen der bereits oben genannten Kriterien gewählten aufeinanderfolgenden k-Raum-Trajektorien verglichen werden.

Werden die erfindungsgemäßen Bildpunkt-Zeit-Serien zur Verwendung mit MRF-Verfahren erstellt, können weitere Optimierungskriterien z.B. auch eine möglichst gute Reduzierung von räumlichen fehlerhaften Abweichungen in den als Ergebnis erhaltenen Parameterkarten und/oder eine möglichst große Homogenität von in den als Ergebnis erhaltenen Parameterkarten angezeigten Parameterwerten in Bereichen gleicher Gewebe sein. Eine derartige Homogenität kann beispielsweise über Referenzmessungen oder durch Messungen an zumindest in Teilbereichen homogenen Phantomen kontrolliert werden.

Werden die erfindungsgemäßen Bildpunkt-Zeit-Serien zur Verwendung mit fMRI-Verfahren erstellt, können weitere Optimierungskriterien z.B. auch eine möglichst zufällige Verteilung der k-Raum-Trajektorien, um eine möglichst unempfindliche sogenannte Baseline aus den Bildpunkt-Zeit-Serien bestimmen zu können oder auch bei einer mehrfachen Anwendung eines gleichen Paradigmas jeweils während verschiedenen Anwendungen des Paradigmas zu gleichen Zeitpunkten des Paradigmas möglichst keine gleichen k-Raum-Trajektorien oder sogar möglichst orthogonale k-Raum-Trajektorien zu verwenden, um einen Mittelungseffekt zu erzielen.

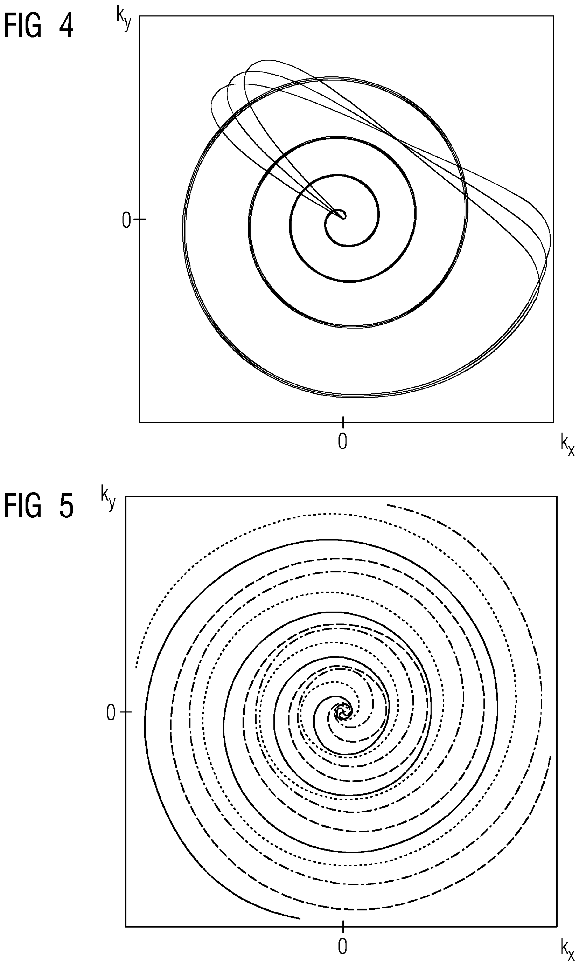

In Figur 4 ist nun ein Beispiel einer gewöhnlichen Wahl von durch Rotation bestimmter dreier in aufeinanderfolgenden Wiederholungen zu verwendender k-Raum-Trajektorien gezeigt. Die gezeigten k-Raum-Trajektorien entsprechen den in Figur 3 gezeigten spiralförmigen k-Raum-Trajektorien, wobei zusätzlich die Rückführung zum k-Raumzentrum mit eingezeichnet ist. In dem gezeigten Beispiel ist jede nachfolgend zu verwendende k-Raum-Trajektorie chronologisch genau um den in Figur 3 angegebenen Rotationsschritt von 7,5° gegenüber der vorhergehenden k-Raum-Trajektorie gewählt. Dies stellt keine optimale Wahl der k-Raum-Trajektorien, entlang derer Messdaten nacheinander aufgenommen werden sollen, dar.

Hingegen ist in Figur 5 ein Beispiel einer erfindungsgemäßen Wahl von vier durch Rotation bestimmter in aufeinanderfolgenden Wiederholungen zu verwendender k-Raum-Trajektorien gezeigt. Die verschiedenen k-Raum-Trajektorien sind hierbei in unterschiedlicher Strichlinienart dargestellt, um eine Unterscheidung zu erleichtern. Die gezeigten erfindungsgemäß gewählten k-Raum-Trajektorien decken den k-Raum bereits nach den wenigen Wiederholungen breiter ab als die in Figur 3 gezeigten. Die in Figur 4 dargestellten k-Raum-Trajektorien wurden zufällig aus den 48 k-Raum-Trajektorien, die in Figur 3 dargestellt sind, ausgewählt.

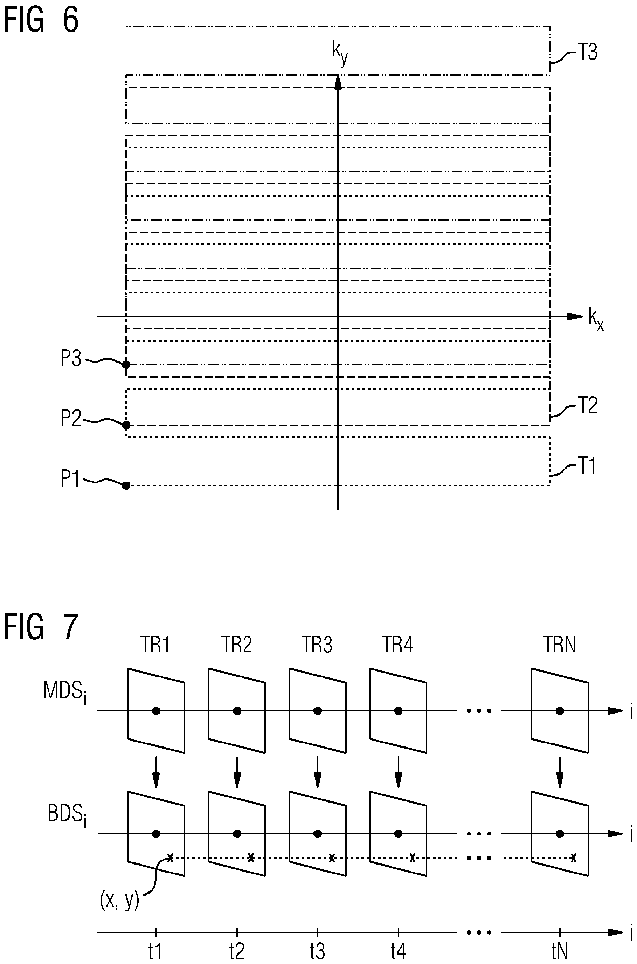

Figur 6 zeigt ein Beispiel einer Auswahl von durch Translation bestimmter weiterer k-Raum-Trajektorien. Die gezeigten k-Raum-Trajektorien entsprechen hier einer kartesischen Abtastung des k-Raums, z.B. gemäß einer EPI Pulssequenz. Die erste k-Raum-Trajektorie T1 startet an dem Startpunkt P1. Die zweite k-Raum-Trajektorie T2, die in der folgenden Wiederholung verwendet werden soll, ist um einen Translationsschritt der 5-fachen kleinsten Translationsschrittweite zwischen zwei im Rahmen aller Wiederholungen zu verwendenden k-Raum-Trajektorien in positiver ky-Richtung verschoben. Die dritte k-Raum-Trajektorie T3, die in der dritten Wiederholung verwendet werden soll, ist wiederum um einen Translationsschritt der 5-fachen kleinsten Translationsschrittweite zwischen zwei im Rahmen aller Wiederholungen zu verwendenden k-Raum-Trajektorien in positiver ky-Richtung gegenüber der vorhergehenden k-Raum-Trajektorie T2 verschoben. Aufeinanderfolgend zu verwendende k-Raum-Trajektorien T1 und T2 bzw. T2 und T3 sind somit nicht chronologisch gemäß der kleinsten Translationsschrittweite zwischen zwei im Rahmen aller Wiederholungen zu verwendenden k-Raum-Trajektorien gegeneinander verschoben, sondern mit einer um den Faktor 5 erhöhten Schrittweite.

Ein derartiges Vielfach-Schritt-Schema kann mit unterschiedlichsten Vielfachen (ungleich Eins), auch nicht-ganzzahligen, durchgeführt werden. Abhängig von der Anzahl der insgesamt zu verwendenden verschiedenen k-Raum-Trajektorien n und der kleinsten Translationsschrittweite zwischen zwei im Rahmen aller Wiederholungen zu verwendenden k-Raum-Trajektorien Tᵢ kann durch die Wahl des Vielfachen z.B. beeinflusst werden, wie gleichmäßig der k-Raum in aufeinanderfolgenden Wiederholungen abgetastet wird. Bei einem kleinen Vielfachen wird der k-Raum beispielsweise in wenigen Wiederholungen nur in einem kleinen Bereich abgedeckt (siehe z.B. ähnlich wie in Figur 3), bei größeren Vielfachen wird bereits mit wenigen Wiederholungen ein größerer Bereich des relevanten k-Raums abgetastet.

Allgemein können die k-Raum-Trajektorien, entlang derer in aufeinanderfolgenden Wiederholungen Messdaten gemessen werden, derart gewählt sein, dass eine k-Raum-Trajektorie durch eine Translation einer unmittelbar vorhergehenden k-Raum-Trajektorie um ein Vielfaches V der kleinsten Translationsschrittweite zwischen zwei im Rahmen aller Wiederholungen zu verwendenden k-Raum-Trajektorien bestimmt ist, wenn die weiteren k-Raum-Trajektorien durch Translation der ersten k-Raum-Trajektorie bestimmt sind.

Analog können die k-Raum-Trajektorien, entlang derer in aufeinanderfolgenden Wiederholungen Messdaten gemessen werden, auch derart gewählt werden, dass eine k-Raum-Trajektorie durch eine Rotation einer unmittelbar vorhergehenden k-Raum-Trajektorie um ein Vielfaches der kleinsten Rotationsschrittweite zwischen zwei im Rahmen aller Wiederholungen zu verwendenden k-Raum-Trajektorien bestimmt ist, wenn die weiteren k-Raum-Trajektorien durch Rotation der ersten k-Raum-Trajektorie bestimmt sind.

Falls durch ein solches Vielfach-Schritt-Schema mit einer schrittweise mit einer Rotations- und/oder Translationsschrittweite von einem Vielfachen einer kleinsten Rotations- bzw. Translationsschrittweite zwischen zwei im Rahmen aller Wiederholungen zu verwendenden k-Raum-Trajektorien Wahl von aufeinanderfolgend zu verwendenden k-Raum-Trajektorien nicht alle zu verwendenden k-Raum-Trajektorien erreicht werden, kann, kann als nächste zu verwendende k-Raum-Trajektorie eine bisher noch nicht verwendete k-Raum-Trajektorie gewählt werden, von der aus das gewünschte Schritt-Schema erneut durchgeführt wird.

Wurden bereits alle N gewünschten Wiederholungen durchgeführt und die entsprechenden N Messdatensätze MSDᵢ gespeichert ("y", Abfrage 105), wird keine weitere Messung durchgeführt ("stop") und es wird für mindestens einen Bildpunkt (x,y) in den rekonstruierten Bilddatensätzen BDSᵢ eine Bildpunkt-Zeit-Serie (x,y)(i) gebildet, die eine Signalintensität des Bildpunktes (x,y) im Verlauf der Aufnahmezeiten (und damit im Verlauf der nacheinander durchgeführten Wiederholungen i) der Messdatensätze MDSᵢ wiedergibt. Üblicherweise wird eine solche Bildpunkt-Zeit-Serie (x,y)(i) für alle Bildpunkte (x,y), die in einem interessierenden Bereich in dem Untersuchungsobjekt liegen durchgeführt. Die gebildeten Bildpunkt-Zeit-Serien (x,y)(i) werden gespeichert.

Dies ist weiter in Figur 7 veranschaulicht, in der schematisch der Zusammenhang von Messdatensätzen MDSᵢ und Bilddatensätzen BDSi im zeitlichen Verlauf, d.h. im Verlauf von i, dargestellt ist.

In der obersten Zeile sind die unterabgetasteten Messdatensätze MDSᵢ, wie sie nacheinander in den Wiederholungen TRᵢ aufgenommen wurden dargestellt, wobei beispielhaft die Wiederholungen i=1, i=2, i=3, i=4 und i=N explizit dargestellt sind. In der zweiten Zeile sind die aus den Messdatensätzen MDSᵢ rekonstruierten Bilddatensätze BDSᵢ in gleicher Weise dargestellt, wobei beispielhaft ein Bildpunkt (x,y) in den Bilddatensätzen BDSᵢ markiert ist. Beispielsweise zu diesem Bildpunkt (x,y) kann die jeweilige Intensität des Bildpunktes (x,y) zu den, den Wiederholungen Tᵢ entsprechenden Zeiten Tᵢ gegen die Zeit, d.h. gegen die Nummer i der Wiederholung als Bildpunkt-Zeit-Serie aufgetragen werden.

Die gespeicherten Bildpunkt-Zeit-Serien (x,y)(i) können weiterhin mit einem Vergleichsdatensatz VDS(i) verglichen werden und aus dem Vergleich als Ergebnis Erg Informationen über das Untersuchungsobjekt gewonnen werden (Block 113).

Hierbei kommen insbesondere MRF-Verfahren und fMRI-Verfahren in Betracht, wobei der Vergleichsdatensatz entsprechend ein Signalverlauf aus einer Magnetresonanz-Fingerprinting-Datenbank, wobei als Ergebnis z.B. eine quantitative T1-Karte und/oder eine quantitative T2-Karte und/oder eine quantitative Protonendichtekarte gewonnen werden können, oder ein Paradigma eines funktionellen Magnetresonanzverfahrens, wobei als Ergebnis Informationen über aktive Gehirnareale gewonnen werden können, sein kann.

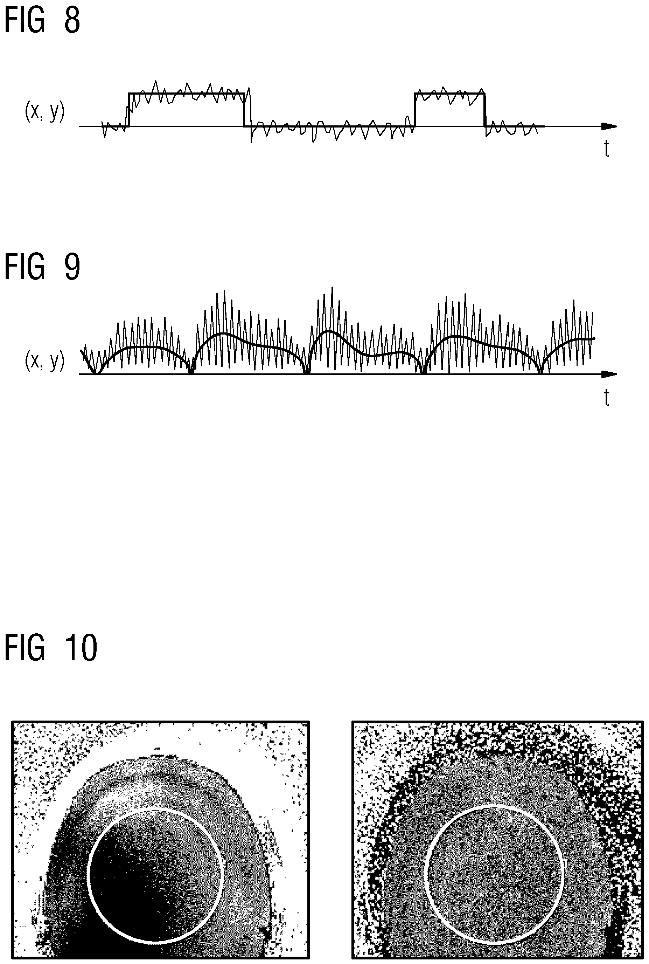

Beispiele für erfindungsgemäß erstellten Bildpunkt-Zeit-Serien sind in den Figuren 8 und 9 dargestellt. Figur 8 zeigt den mit einer dünneren Linie dargestellten Verlauf der Intensitäten eines Bildpunktes (x,y) über der Zeit im Vergleich zu einem mit fetterer Linie dargestellten fMRI-Paradigma als Vergleichsdatensatz, zu dem gewisse Stimuli auf das Untersuchungsobjekt wirkten. In Figur 9 ist ein Intensitätsverlauf eines Bildpunktes (x,y) über der Zeit mit einer dünneren Linie im Vergleich zu dem mit dickerer Linie dargestellten gefitteten Signalverlauf aus der MRF-Datenbank als Vergleichsdatensatz dargestellt. Trotz der Unterabtastung der den einzelnen Bilddatensätzen zugrunde liegenden Messdatensätze und den damit verbundenen Schwankungen der Intensitätswerte der erfindungsgemäßen Bildpunkt-Zeit-Serien, liegen die jeweiligen Vergleichsdatensätze gut im Mittel der Schwankungen. Das zeigt, dass räumliche wie auch (besonders im Falle der Anwendung bei fMRI) zeitliche Verschiebung von Intensitätswerten in den rekonstruierten Bilddatensätzen durch die erfindungsgemäße Erstellung der Bildpunkt-Zeit-Serien vermieden wurden.

Figur 10 vergleicht eine nicht auf Grundlage von erfindungsgemäß erzeugten Bildpunkt-Zeit-Serien ermittelte Parameterkarte (links) mit einer entsprechenden auf Grundlage von erfindungsgemäß erzeugten Bildpunkt-Zeit-Serien ermittelten Parameterkarte (rechts). In der links dargestellten Parameterkarte sind deutlich Abschattungs-Artefakte (engl. "shading artifacts") zu sehen, wohingegen derartige Artefakte in der aus mit dem erfindungsgemäßen Verfahren erstellten Bildpunkt-Zeit-Serien, ansonsten in gleicher Weise ermittelten, rechts dargestellten Parameterkarte nicht zu sehen sind. Die Verwendung der erfindungsgemäß erzeugten Bildpunkt-Zeit-Serie für die Ermittlung der Parameterkarte hat somit zu einer Verringerung, wenn nicht gar vollständigen, Vermeidung der ungewünschten Artefakte geführt.

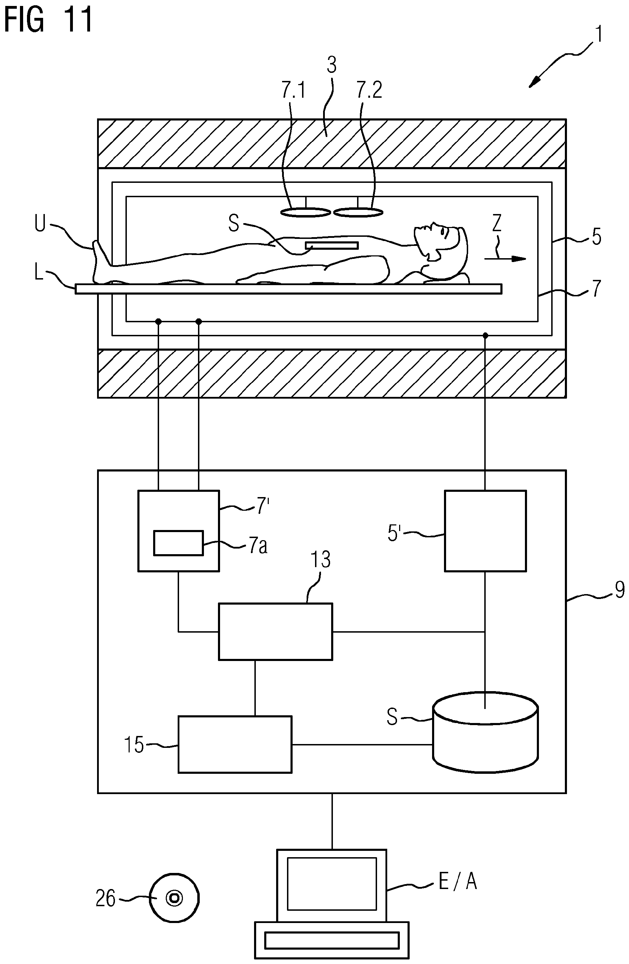

Figur 11 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 11 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht S stellt ein exemplarisches Zielvolumen des Untersuchungsobjekts dar, aus dem Messdaten aufgenommen werden können.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei muss die Mittenfrequenz des, auch als B1-Feld bezeichneten, Hochfrequenz-Wechselfeldes nahe der Resonanzfrequenz der zu manipulierenden Spins liegen. Zur Erzeugung des B1-Feldes werden in der Hochfrequenzeinheit 7 mittels der Hochfrequenz-sende/empfangs-Steuerung 7' gesteuerte Ströme an den HF-Spulen angelegt. Eine erfindungsgemäße Messdatenaufteilungseinheit 7a, die beispielsweise von der Hochfrequenz-Sende-/Empfangs-Steuerung 7` umfasst sein kann, bestimmt welche Messdaten erfindungsgemäß aufgenommen und welchem Datensatz zugeordnet werden.

Weiterhin umfasst die Steuereinrichtung 9 eine Optimierungseinheit 15, mit welcher k-Raum-Trajektorien erfindungsgemäß optimiert gewählt werden können. Die Steuereinrichtung 9 ist insgesamt dazu ausgebildet, ein erfindungsgemäßes Verfahren zur Vermeidung von Artefakten bei der Akquisition von MR-Daten eines Untersuchungsobjekts durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

## Patentansprüche

1. Verfahren zur Erzeugung einer Bildpunkt-Zeit-Serie ((x,y) (i)) eines Untersuchungsobjektes (U) mittels Magnetresonanztechnik, umfassend die Schritte:
- In einer ersten Wiederholung, Einstrahlen von RF-Pulsen (RF-Aᵢ, RF-Aᵢ₊₁), Schalten von Gradienten (GTᵢ) und Auslesen (Rᵢ) von durch die eingestrahlten RF-Pulse (RF-Aᵢ, RF-Ai+1) und die geschalteten Gradienten (GTᵢ) erzeugten Echosignalen (ESᵢ) gemäß einer Pulssequenz derart, dass entlang einer ersten k-Raum-Trajektorie (Tᵢ) Messdaten nach einer Anregung mit einem RF-Anregungspuls (RF-Aᵢ) aufgenommen und in einem Messdatensatz (MDSᵢ) gespeichert werden, wobei der Messdatensatz (MDSᵢ) gemäß Nyquist unterabgetastet ist,
- mehrmaliges Wiederholen der Pulssequenz unter Schaltung von jeweils anderen Gradienten (GTᵢ) und optional unter Einstrahlung von jeweils anderen RF-Pulsen (RF-Aᵢ₊₁) derart,
dass bei jeder Wiederholung nach dem einen RF-Anregungspuls (RF-Aᵢ₊₁) Messdaten entlang einer weiteren k-Raum-Trajektorie (Tᵢ₊₁) gemessen und in jeweiligen Messdatensätzen (MDSᵢ) gespeichert werden,
- Rekonstruieren eines Bilddatensatzes (BDSᵢ) pro Messdatensatz (MDSᵢ),
- Bilden mindestens einer Bildpunkt-Zeit-Serie ((x,y)(i)) für mindestens einen Bildpunkt ((x,y)) aus den rekonstruierten Bilddatensätzen (BDSᵢ), die eine Signalintensität des Bildpunktes ((x,y)) im Verlauf der Aufnahmezeiten der Messdatensätze (MDSᵢ) wiedergibt,
- Speichern der mindestens einen gebildeten Bildpunkt-Zeit-Serie ((x,y)(i)), **dadurch gekennzeichnet, dass** die Wiederholungen derart durchgeführt werden, dass in aufeinanderfolgenden Wiederholungen Messdaten entlang optimiert gewählten k-Raum-Trajektorien (Ti+1) gemessen werden, wobei für die Optimierung Ergebnisse von nach verschiedenen Kriterien gewählten aufeinanderfolgenden k-Raum-Trajektorien verglichen werden,
wobei die Wahl der nacheinander zu messenden k-Raum-Trajektorien (Tᵢ, Tᵢ₊₁) gemäß mindestens eines der folgenden Kriterien optimiert ist: eine Reduzierung von Artefakten in den rekonstruierten Bilddatensätzen, eine Reduzierung einer räumlichen und/oder zeitlichen Verschiebung von Intensitätswerten in den rekonstruierten Bilddatensätzen, und
wobei die weiteren k-Raum-Trajektorien (Tᵢ₊₁) durch eine schrittweise Rotation gemäß einer Rotationsschrittweite und/oder durch eine schrittweise Translation gemäß einer Translationsschrittweite bestimmt sind, und
wobei die k-Raum-Trajektorien (Tᵢ, Tᵢ₊₁), entlang derer in aufeinanderfolgenden Wiederholungen Messdaten gemessen werden, derart gewählt sind, dass eine k-Raum-Trajektorie (Tᵢ₊₁) durch eine Rotation einer unmittelbar vorhergehenden k-Raum-Trajektorie (Tᵢ) um ein Vielfaches einer kleinsten Rotationsschrittweite zwischen zwei im Rahmen aller Wiederholungen zu verwendenden k-Raum-Trajektorien bestimmt ist, wenn die weiteren k-Raum-Trajektorien durch Rotation der ersten k-Raum-Trajektorie bestimmt sind, und/oder dass eine k-Raum-Trajektorie (Tᵢ₊₁) durch eine Translation einer unmittelbar vorhergehenden k-Raum-Trajektorie (Tᵢ) um ein Vielfaches einer kleinsten Translationsschrittweite zwischen zwei im Rahmen aller Wiederholungen zu verwendenden k-Raum-Trajektorien bestimmt ist, wenn die weiteren k-Raum-Trajektorien durch Translation der ersten k-Raum-Trajektorie bestimmt sind.

2. Verfahren nach Anspruch 1, wobei jede weitere k-Raum-Trajektorie (Tᵢ₊₁) durch Anwenden einer Rotation und/oder einer Translation auf die erste k-Raum-Trajektorie (Tᵢ) und/oder durch Einsatz einer anderen geometrischen Operation auf eine andere k-Raum-Trajektorie bestimmt ist.

3. Verfahren nach einem der vorhergehenden Ansprüche, wobei die k-Raum-Trajektorien (Tᵢ, Tᵢ₊₁) entlang derer Messdaten in einer Wiederholung gemessen werden den k-Raum kartesisch, spiralförmig oder radial abtasten.

4. Verfahren nach einem der vorhergehenden Ansprüche, wobei gespeicherte Bildpunkt-Zeit-Serien ((x,y)(i)) mit einem Vergleichsdatensatz (VDS(i)) verglichen werden und aus dem Vergleich Informationen über das Untersuchungsobjekt (U) gewonnen werden.

5. Verfahren nach Anspruch 4, wobei der Vergleichsdatensatz (VDS(i)) ein Signalverlauf aus einer Magnetresonanz-Fingerprinting-Datenbank oder ein Paradigma eines funktionellen Magnetresonanzverfahrens ist.

6. Verfahren nach einem der vorhergehenden Ansprüche, wobei die Wahl der k-Raum-Trajektorien (Tᵢ, Tᵢ₊₁), entlang derer in aufeinanderfolgenden Wiederholungen Messdaten gemessen werden sollen, eine Anzahl (n) an verschiedenen insgesamt anzuwendenden k-Raum-Trajektorien und/oder einen Grad der Unterabtastung eines aufgenommenen Messdatensatzes (MDSᵢ) berücksichtigt.

7. Verfahren nach einem der vorhergehenden Ansprüche, wobei die Wahl der k-Raum-Trajektorien (Tᵢ, Tᵢ₊₁), entlang derer in aufeinanderfolgenden Wiederholungen Messdaten gemessen werden, eine Menge von verschiedenen k-Raum-Trajektorien, entlang derer zumindest einmal Messdaten gemessen werden sollen, berücksichtigt, und die k-Raum-Trajektorien (Tᵢ, Tᵢ₊₁) derart gewählt werden, dass in aufeinanderfolgenden Wiederholungen Messdaten entlang von zufällig aus der Menge der verschiedenen k-Raum-Trajektorien gewählten k-Raum-Trajektorien und/oder die k-Raum-Trajektorien derart gewählt werden, dass in aufeinanderfolgenden Wiederholungen Messdaten entlang von k-Raum-Trajektorien, die alternierende Gradienten aufweisen, gemessen werden.

8. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7`), **dadurch gekennzeichnet, dass** die Steuereinrichtung (9) eine Optimierungseinheit (15), mit welcher k-Raum-Trajektorien optimiert gewählt werden können, umfasst und dazu ausgebildet ist, ein Verfahren nach einem der Ansprüche 1 bis 7 auf der Magnetresonanzanlage (1) auszuführen.

9. Computerprogrammprodukt, welches ein Computerprogramm umfasst und direkt in einen Speicher einer Steuereinrichtung (9) einer Magnetresonanzanlage (1) ladbar ist, **dadurch gekennzeichnet, dass** das Computerprogramm Programm-Mittel umfasst, um die Schritte des Verfahrens nach einem der Ansprüche 1 bis 7 auszuführen, wenn das Computerprogramm in der Steuereinrichtung (9) der Magnetresonanzanlage (1) ausgeführt wird.

10. Elektronisch lesbarer Datenträger mit darauf gespeicherten elektronisch lesbaren Steuerinformationen, **dadurch gekennzeichnet, dass** die auf dem elektronisch lesbaren Datenträger gespeicherten elektronisch lesbaren Steuerinformationen zumindest ein Computerprogramm wie in Anspruch 9 definiert umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 7 durchführen.

## Claims

1. Method for the generation of a pixel-time series ((x,y)(i)) of an examination object (U) by means of magnetic resonance technology comprising the steps:
- in a first repetition, irradiation of RF pulses (RF-Aᵢ, RF-Aᵢ₊₁), switching of gradients (GTᵢ) and reading-out (Rᵢ) of echo signals (ESᵢ) generated by the irradiated RF pulses (RF-Aᵢ, RF-Ai+1) and the switched gradients (GTᵢ) according to a pulse sequence such that, after excitation with an RF excitation pulse (RF Aᵢ), measurement data is recorded along a first k-space trajectory (Tᵢ) and stored in a measurement data set (MDSᵢ), wherein the measurement data set (MDSᵢ) is undersampled according to the Nyquist theorem,
- multiple repetition of the pulse sequence with switching in each case of other gradients (GTᵢ) and optionally with irradiation in each case of other RF pulses (RF-Aᵢ₊₁) such that, on each repetition, after the one RF excitation pulse (RF-Aᵢ₊₁), measurement data is measured along a further k-space trajectory (Tᵢ₊₁) and stored in respective measurement data sets (MDSᵢ),
- reconstruction of an image data set (BDSᵢ) for each measurement data set (MDSᵢ),
- formation of at least one pixel-time series ((x,y)(i)) for at least one pixel ((x,y)) from the reconstructed image data sets (BDSᵢ) that reproduces a signal intensity of the pixel ((x,y)) during the course of the recording times of the measurement data sets (MDSᵢ),
- storage of the at least one pixel-time series ((x,y)(i)) formed, **characterised in that**
the repetitions are performed such that measurement data is measured along an optimised selection of k-space trajectories (Tᵢ₊₁) in successive repetitions, wherein results of successive k-space trajectories selected according to different criteria are compared for the optimisation,
wherein the selection of the k-space trajectories (Tᵢ, Tᵢ₊₁) to be measured in succession is optimised according to at least one of the following criteria: reduction of artifacts in the reconstructed image data sets, reduction of a spatial and/or temporal shift of intensity values in the reconstructed image data sets, and
wherein the further k-space trajectories (Tᵢ₊₁) are determined by incremental rotation according to a rotation increment and/or by incremental translation according to a translation increment, and
wherein the k-space trajectories (Tᵢ, Tᵢ₊₁), along which measurement data is measured in successive repetitions are selected such that a k-space trajectory (Tᵢ₊₁) is determined by rotation of a directly preceding k-space trajectory (Tᵢ) by a multiple of a smallest rotation increment between two k-space trajectories to be used within all the repetitions when the further k-space trajectories are determined by rotation of the first k-space trajectory, and/or that a k-space trajectory (Tᵢ₊₁) is determined by translation of a directly preceding k-space trajectory (Tᵢ) by a multiple of a smallest translation increment between two k-space trajectories to be used within all the repetitions when the further k-space trajectories are determined by translation of the first k-space trajectory.

2. Method according to claim 1, wherein each further k-space trajectory (Tᵢ₊₁) is determined by applying a rotation and/or a translation to the first k-space trajectory (Tᵢ) and/or by using another geometric operation on another k-space trajectory.

3. Method according to one of the preceding claims, wherein the k-space trajectories (Tᵢ, Tᵢ₊₁) along which measurement data is measured in a repetition sample the k-space with Cartesian, spiral or radial sampling.

4. Method according to one of the preceding claims, wherein stored pixel-time series ((x,y)(i)) are compared with a comparison data set (VDS(i)) and information on the examination object (U) is obtained from the comparison.

5. Method according to claim 4, wherein the comparison data set (VDS(i)) is a signal profile from a magnetic resonance fingerprinting database or a paradigm of a functional magnetic resonance method.

6. Method according to one of the preceding claims, wherein the selection of the k-space trajectories (Tᵢ, Tᵢ₊₁), along which measurement data is to be measured in successive repetitions, takes account of a number (n) of different k-space trajectories to be used overall and/or a degree of undersampling of a recorded measurement data set (MDSᵢ).

7. Method according to one of the preceding claims, wherein the selection of the k-space trajectories (Tᵢ, Tᵢ₊₁), along which measurement data is measured in successive repetitions, takes account of a set of different k-space trajectories, along which measurement data is to be measured at least once, and the k-space trajectories (Tᵢ, Tᵢ₊₁)are selected such that, in successive repetitions, measurement data is measured along k-space trajectories selected randomly from the set of different k-space trajectories and/or the k-space trajectories are selected such that measurement data is measured along k-space trajectories with alternating gradients in successive repetitions.

8. Magnetic resonance system (1) comprising a magnet unit (3), a gradient unit (5), a radio-frequency unit (7) and a control facility (9) with a radio-frequency transceiver control system (7`), **characterised in that** the control facility (9) comprises an optimisation unit (15), with which k-space trajectories can be selected in an optimised manner, and is embodied to carry out a method according to one of claims 1 to 7 on the magnetic resonance system (1).

9. Computer program product, which comprises a computer program and can be loaded directly into a memory of a control facility (9) of a magnetic resonance system (1), **characterised in that** the computer program comprises program means for carrying out the steps of the method according to one of claims 1 to 7 when the computer program is executed in the control facility (9) of the magnetic resonance system (1).

10. Electronically readable data medium with electronically readable control information stored thereupon, **characterised in that** the electronically readable control information stored on the electronically readable data medium comprises at least one computer program as defined in claim 9 and is embodied to carry out a method according to one of claims 1 to 7 when the data medium is used in a control facility (9) of a magnetic resonance system (1).

## Revendications

1. Procédé de production d'une série ((x, y)(i)) de points image - temps d'un objet (U) à examiner, au moyen d'une technique de résonnance magnétique, comprenant les stades :
- dans une première répétition, arrivée d'impulsions RF (RF-Aᵢ, RF-Aᵢ₊₁), commutation de gradients (GTᵢ) et lecture (Rᵢ) de signaux (ESᵢ) d'écho produits par les impulsions RF (RF-Aᵢ, RF-Ai+1) arrivées et les gradients (GTᵢ) commutés suivant une séquence d'impulsions, de manière à enregistrer, le long d'une première trajectoire (Tᵢ) dans l'espace k, des données de mesure après une excitation par une impulsion d'excitation RF (RF-Aᵢ) et à les mettre en mémoire en un ensemble (MDSᵢ) de données de mesure, dans lequel l'ensemble (MDSᵢ) de données de mesure est sous-échantillonné suivant Nyquist,
- répétition plusieurs fois de la séquence d'impulsions avec commutation de respectivement d'autres gradients (GTᵢ) et éventuellement avec arrivée respectivement d'autres impulsions RF (RF-Aᵢ₊₁), de manière à ce que,
à chaque répétition, après la une impulsion d'excitation RF (RF-Aᵢ₊₁), on mesure des données de mesure, le long d'une autre trajectoire (Tᵢ₊₁) dans l'espace k et on les met en mémoire en des ensembles (MDSᵢ) respectifs de données de mesure,
- reconstruction d'un ensemble (BDSᵢ) de données d'image par ensemble (MDSᵢ) de données de mesure,
- formation d'au moins une série ((x, y)(i)) de points image - temps pour au moins un point image ((x, y)), à partir des ensembles (BDSᵢ) de données d'image reconstruits, qui représentent une intensité de signal du point image ((x, y)) au cours des temps d'enregistrement des ensembles (MDSᵢ) de données de mesure,
- mise en mémoire de la au moins une série ((x, y)(i)) de points image - temps formée, **caractérisé en ce que** l'on effectue les répétitions, de manière à ce que, dans des répétitions successives, des données d'image soient mesurées de long de trajectoires (Ti+1) dans l'espace k sélectionnées de manière optimisée, dans lequel, pour l'optimisation, on compare des résultats de trajectoires dans l'espace k successives choisies suivant des critères différents,
dans lequel le choix des trajectoires (Tᵢ, Tᵢ₊₁) dans l'espace k, à mesurer les unes après les autres est optimisé suivant au moins l'un des critères suivants : une réduction d'artefacts dans les ensembles de données d'image reconstruits, une réduction d'un décalage dans l'espace et/ou dans le temps de valeurs d'intensité dans les ensembles de données d'image reconstruits, et dans lequel les autres trajectoires (Tᵢ₊₁) dans l'espace k sont déterminées par une rotation pas à pas, suivant une largeur de pas de rotation, et/ou par une translation pas à pas, suivant une largeur de pas de translation, et
dans lequel on choisit les trajectoires (Tᵢ, Tᵢ₊₁) dans l'espace k le long desquelles on mesure des données de mesure en des répétitions successives, de manière à ce qu'une trajectoire (Tᵢ₊₁) dans l'espace k soit déterminée par une rotation d'une trajectoire (Tᵢ) dans l'espace k immédiatement précédente d'un multiple d'une largeur de pas de rotation la plus petite entre deux trajectoires dans l'espace k à utiliser dans le cadre de toutes les répétitions, si les autres trajectoires dans l'espace k sont déterminées par rotation de la première trajectoire dans l'espace k, et/ou de manière à ce qu'une trajectoire (Tᵢ₊₁) dans l'espace k soit déterminée par une translation d'une trajectoire (Tᵢ) dans l'espace k immédiatement précédente d'un multiple d'une largeur de pas de translation la plus petite entre deux trajectoires dans l'espace k, à utiliser dans le cadre de toutes les répétitions, si les autres trajectoires dans l'espace k sont déterminées par translation de la première trajectoire dans l'espace k.

2. Procédé suivant la revendication 1, dans lequel chaque trajectoire (Tᵢ₊₁) dans l'espace k est déterminée par application d'une rotation et/ou d'une translation à la première trajectoire (Tᵢ) dans l'espace k et/ou par utilisation d'une autre opération géométrique sur une autre trajectoire dans l'espace k.

3. Procédé suivant l'une des revendications précédentes, dans lequel les trajectoires (Tᵢ, Tᵢ₊₁) dans l'espace k, le long desquelles on mesure des données de mesure dans une répétition, balayent cartésiennement, en forme de spirale ou radialement l'espace k.

4. Procédé suivant l'une des revendications précédentes, dans lequel on compare des séries ((x,y)(i)) de points image - temps mises en mémoire à un ensemble (VDS(i)) de données de comparaison et, à partir de la comparaison, on obtient des informations sur l'objet (U) à examiner.

5. Procédé suivant la revendication 4, dans lequel l'ensemble (VDS(i)) de données de comparaison est une courbe de signal d'empreinte digitale de résonnance magnétique ou un paradigme d'un procédé fonctionnel par résonnance magnétique.

6. Procédé suivant l'une des revendications précédentes, dans lequel le choix des trajectoires (Tᵢ, Tᵢ₊₁) dans l'espace k, le long desquelles on doit mesurer des données de mesure en des répétitions successives, prend en compte un nombre (n) de diverses trajectoires dans l'espace à appliquer dans l'ensemble et/ou un degré du sous-échantillonnage d'un ensemble (MDSᵢ) de données de mesure enregistré.

7. Procédé suivant l'une des revendications précédentes, dans lequel le choix des trajectoires (Tᵢ, Tᵢ₊₁) dans l'espace k, le long desquelles on mesure des données de mesure en des répétitions successives, prend en compte un ensemble de trajectoires dans l'espace k différentes, le long desquelles on doit mesurer au moins une fois des données de mesure et on choisit les trajectoires (Tᵢ, Tᵢ₊₁₎ dans l'espace k, de manière à mesurer, dans des répétitions successives, des données de mesure, le long de trajectoires dans l'espace k choisies aléatoirement dans l'ensemble de trajectoires dans l'espace k différentes et/ou on choisit les trajectoires dans l'espace k, de manière à ce que, dans des répétitions successives, on mesure des données de mesure, le long de trajectoires de l'espace k, qui ont des gradients en alternance.

8. Installation (1) de résonnance magnétique, comprenant une unité (3) d'aimant, une unité (5) de gradient, une unité (7) de haute fréquence et un dispositif (9) de commande ayant une commande (7') d'émission / réception de haute fréquence, **caractérisée en ce que** le dispositif (9) de commande comprend une unité (15) d'optimisation, par laquelle on peut choisir, de manière optimisée, des trajectoires dans l'espace k et qui est constituée pour effectuer un procédé suivant l'une des revendications 1 à 7 sur l'installation (1) de résonnance magnétique.

9. Produit de programme d'ordinateur, qui comprend un programme d'ordinateur et qui peut être chargé directement dans une mémoire d'un dispositif (9) de commande d'une installation (1) de résonnance magnétique, **caractérisé en ce que** le programme d'ordinateur comprend des moyens de programme pour effectuer les stades du procédé suivant l'une des revendications 1 à 7, lorsque le programme d'ordinateur est réalisé dans le dispositif (9) de commande de l'installation (1) de résonnance magnétique.

10. Support de données, déchiffrable électroniquement, sur lequel sont mises en mémoire des informations de commande pouvant être déchiffrées électroniquement, **caractérisé en ce que** les informations de commande, pouvant être déchiffrées électroniquement, mises en mémoire sur le support de données pouvant être déchiffré électroniquement, comprennent au moins un programme d'ordinateur tel que défini à la revendication 9, et sont conformées de manière à ce qu'elles effectuent, lors de l'utilisation du support de données dans un dispositif (9) de commande d'une installation (1) de résonnance magnétique, un procédé suivant l'une des revendications 1 à 7.
